# EUROPEAN PATENT APPLICATION

(11) **EP 1 429 149 A2**
(43) Date of publication of application: **16.06.2004**
(21) Application number: 03257727.2
(22) Date of filing: 09.12.2003
(51) Int. Cl.: G01R 19/165

(54) **A device for detecting a hazardous potential difference between conductor rails of a railway track**

(30) Priority: 09.12.2002 GB 0228692
(71) Applicant: London Underground Limited, Westminster London SW1H OBD (GB)
(72) Inventor: Payne, Kevin c/o London Underground Limited, London SW1H 0BD (GB)
(74) Representative: Howson, Richard G.B.

(57) **Abstract**

A device (10) includes an operator housing (20) and an indicator housing (30). The two housings (20, 30) are connected to one another by a length of electrical cable (40). Each housing (20, 30) includes a respective handle (22, 32) on an upper surface thereof and a respective rail terminal plate (50) mounted in a lower surface thereof. The indicator housing (30) additionally includes a number of LED's mounted in its upper surface. In use, the device (10) is placed against conductor rails of a railway track such that the rail terminal plate (50) of each housing (20, 30) is in contact with a respective one of the conductor rails. The device (10) is arranged such that the presence of a large potential difference across the conductor rails causes the LED's mounted in the indicator housing (30) to flash on and off. The device (10) is additionally provided with a self-test facility, whereby the rail terminal plate (50) can be placed together and a button (24) in the operator housing (20) depressed to establish a test current through the device (10). Correct functioning is then indicated by the LED's flashing on and off.

## Description

This invention relates to a device for detecting a potentially hazardous potential difference between conductor rails of a railway track.

During maintenance of railway track that includes conductor rails, it may be necessary to disconnect from those conductor rails from a supply of a normal operating potential difference in order to avoid injury to track-side workers that would result from contact with that potential difference. It is usual for such workers to ascertain whether the conductor rails have been disconnected from the supply of potential difference before commencing work. To do this, a device may be used to detect whether or not the normal operating potential difference exists between the conductor rails.

It is an object of this invention to provide an improved device for this purpose.

According to an aspect of this invention, there is provided, a device for detecting a potentially hazardous potential difference between conductor rails of a railway track, the device including first and second portions electrically connected to one another, each portion including electrical contact means for placing in electrical contact with a respective one of the conductor rails, and at least one of the portions including indicator means to indicate to a user whether or not a potentially hazardous potential difference exists between the conductor rails when the electrical contact means are so placed, wherein the device is further arranged to self-test when the electrical contact means of each portion are placed in contact with each other.

This arrangement is advantageous in that operation of the device can be tested other than on live track, thereby minimising the risk to an operator in the event that the device is faulty. Furthermore, the device can conveniently be tested by an operator by the track-side and away from a test rig.

Preferably the device is arranged to self-test by establishing a potential difference between the electrical contact means of each portion of the device such that when those means are placed in contact with each other a current flows in the device and the indicator means is operated, thereby checking that the device may be used to indicate whether or not a potentially hazardous potential difference exists between conductor rails.

The indicator means may include a plurality of groups of indicators, each group being operable by a respective circuit running between the electrical contact means of the first portion and the electrical contact means of the second portion. Each group preferably includes a respective electrical connection between the first portion and the second portion. Each group includes one or more indicators. Preferably, there are three groups of indicators, each being part of, and operable by, a respective one of the circuits. The indicator means may include one or more LEDs. Each group preferably includes four LEDs, a respective LED of each group being placed together in a juxtaposed cluster on the at least one of the portions to give four such juxtaposed clusters, each spaced from the other and arranged to maximise the likelihood of the LEDs being seen by a user. Preferably the juxtaposed clusters are arranged such that at least two such clusters can be seen by the user during normal operation.

Preferably, the device is arranged such that the LEDs flash on and off when the electrical contact means are placed in contact with a potentially hazardous potential difference. The preferred rate of flashing is 78 flashes per minute. Such a rate is advantageous in that it is thought to be outside a range of rates of flashing that can give rise to fitting in certain persons.

The indicator means may include an audible indicator, such as an alarm, buzzer or some such similar means.

Preferably the device includes a power source, such as a battery, operable to establish the potential difference between the electrical contact means of each portion of the device during the self-test. The device may also include switch means operable to connect the power source across the electrical contact means for carrying out of the self-test. The switch means is preferably a button provided on one of the portions and operable by a user. The power source is preferably contained within one of the portions. The device preferably includes power source indicator means that is operable during the self-test, preferably by operation of the switch means, to give an indication indicative of strength and/or predicted useful life of the power source. The power source indicator means may be an LED.

Each portion may include a respective, substantially closed, housing. Each housing may include the respective electrical contact means mounted therein. Each housing may include a handle arranged for gripping by a user and such that each of the electrical contact means can be placed in contact with a respective one of the conductor rails. The electrical connection between the first portion and the second portion may be provided by an electrical cable extending between the two housings.

Preferably each portion includes a handle arranged such that that portion can be placed in contact with one of the conductor rails with minimum risk of human contact with the rails. Preferably the device is arranged to protect an operator against arcing, electric shock, fire and/or explosion.

According to another aspect of this invention, there is provided a method of operating the device defined in the first aspect of this invention, the method including the steps of:
a) carrying out a first self-test of the device;
b) placing the electrical contact means of each portion of the device in contact with a respective one of the conductor rails; and
c) carrying out a second self-test of the device.

A specific device in which the invention is embodied is now described by way of example only and with reference to the accompanying drawings, in which:
Figure 1 is a perspective view of the device;
Figure 1A is a perspective view of the cable of the device;
Figure 1B is a perspective view of the cable;
Figure 1C is a sectional view of the cable;
Figure 2 is a detailed sectional view of indicator means of the device;
Figure 3 is an underneath view of a one portion of the device;
Figure 4 is a sectional view of electrical contact means of the device;
Figure 5 is a circuit diagram of test circuitry of the device; and
Figure 6 is a circuit diagram of detect and drive circuitry of the device.

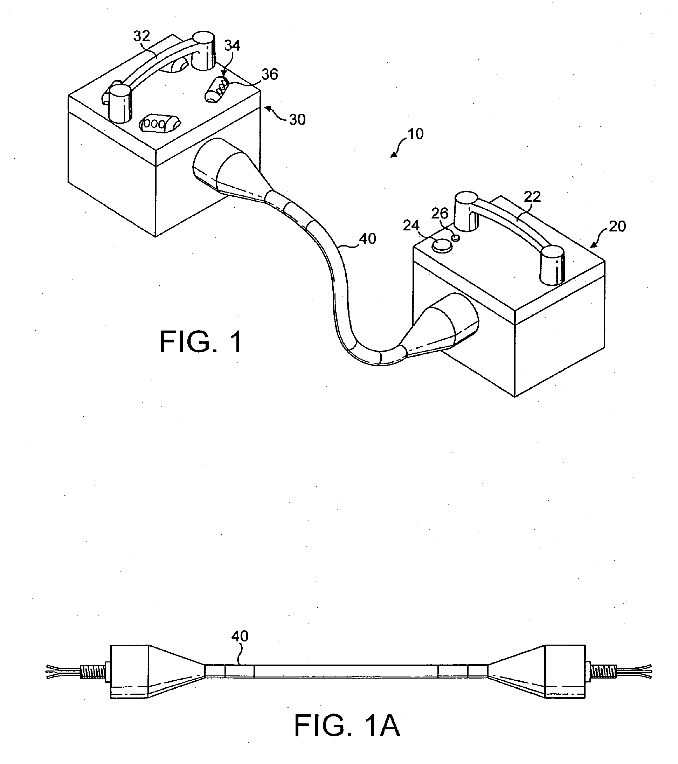

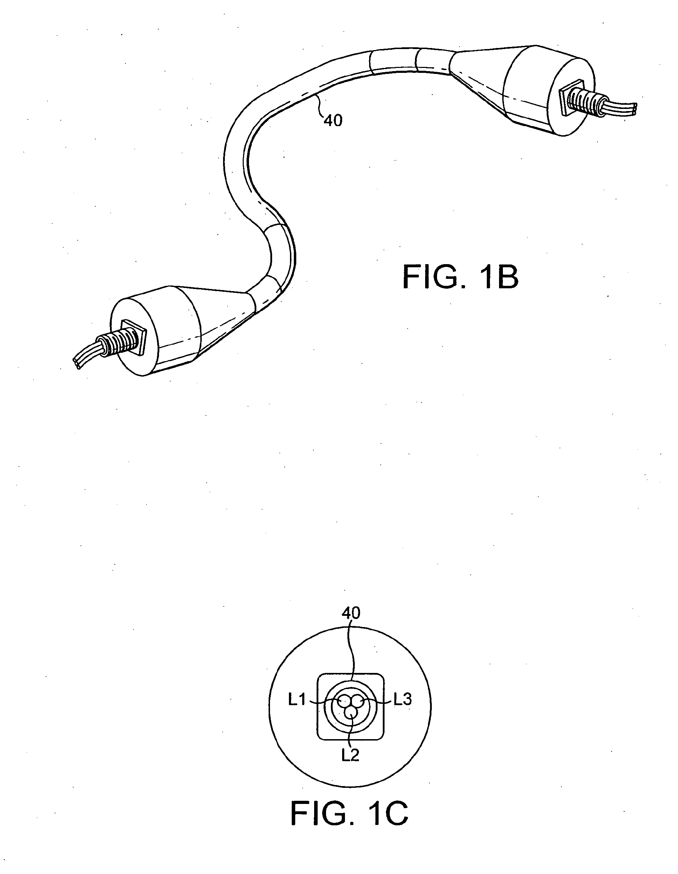

Figure 1 shows the device 10 including a first portion in the form of an operator housing 20 and a second portion in the form of an indicator housing 30. The two housings 20,30 are connected to one another by a length of electrical cable 40, which is shown in more detail in Figures 1A, 1B and 1C. With reference to Figures 1A, 1B and 1C, the cable includes three cores L1, L2, L3, each insulated to 1000V. With reference again to Figure 1, each housing 20, 30 is substantially cuboid and has a respective handle 22,32 fitted to the upper surface thereof.

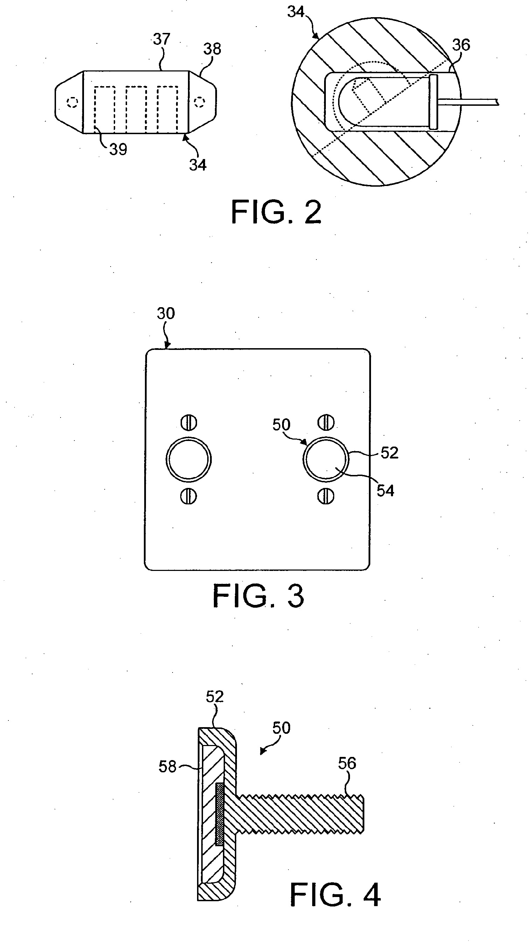

The operator housing 20 includes a button 24 and a power source indicator means in the form of an LED 26 mounted in the upper surface thereof. The indicator housing 30 includes four spaced-apart clusters 34 of LEDs, each including three juxtaposed LEDs 36. Each cluster 34 is mounted adjacent a respective comer of the upper surface of the indicator housing 30. The LEDs 36 of each cluster 34 are arranged in a respective line and so as to face outwards from the indicator housing 30. The clusters 34 are shown in more detail in Figure 2. With reference to Figure 2, each cluster 34 includes a body portion 37 that is substantially cylindrical and with a flanged mounting portion 38 projecting from each end thereof. Each cluster is formed from cast acrylic clear rod, with an approximately 92% transmission of light characteristic. The body portion 37 of each cluster 34 includes three LED-receiving hollows 39 formed therein. The three hollows 39 are positioned side-by-side, in a series, and project parallel to each other. The hollows 39 are arranged such that, when the respective three LED's 36 are received therein, and each cluster 34 is mounted on the indicator housing 30 by way of the respective two mounting portions 38, the light-emitting top of each LED 36 is positioned to project at 35° degrees above the horizontal. Each cluster 34 is so mounted as to be adjacent a respective comer of the upper surface of the indicator housing 30, with the LEDs 36 of the cluster 34 projecting towards that comer. This is to maximise the likelihood of the LEDs 36 being seen by an operator during use.

Figure 3 shows an underside of the indicator housing 30. This underside includes electrical contact means in the form of two rail terminal plates 50. The rail terminal plates 50 are comprised of a shallow, cup-shaped, outer casing 52 with a neodymium-iron-boron rare earth magnet 54 held therein. The outer casing 52 serves as a current carrying portion of the rail terminal plate and is shown in more detail in Figure 4. With reference to Figure 4, the outer casing 52 of each rail terminal plate 50 includes a threaded stud 56 projecting from a base thereof and for affixing the terminal plate 50 to the underside of the indicator housing 30. The inside of the outer casing 52 includes high impact polystyrene 58 to act as magnet retaining material and to minimise the likelihood of damage to the magnet 54 held in the outer casing 52.

Although not shown in the drawings, the underside of operator housing 20 is provided with two rail terminal plates that are substantially the same as those just described with reference to Figure 3. However, the polarity of the outward-facing faces of the magnets of the rail terminal plates of the operator housing 20 is the opposite to that of the outward-facing faces of the magnets 54 of the rail terminal plates 50 of the indicator housing 30. These opposite polarities are to allow the rail terminal plates of each of the housings 20,30 to be placed together, as will be described below with reference to the operation of the device 10.

With reference again to Figure 1, both the operator housing 20 and the indicator housing 30 include respective circuitry (not shown in Figure 1) contained and mounted therein. The circuitry in the operator housing 20 is in electrical contact with the rail terminal plates of that housing 20. The circuitry of the indicator housing 30 is in electrical contact with the rail terminal plates 50 of that housing 30. The circuitry in each housing is in electrical contact with that in the respective other housing via the electrical cable 40. Thus, the rail terminal plates of each housing 20,30 form terminals of a circuit that includes the circuitry of the operator housing 20, the electrical cable 40 and the circuitry of the indicator housing 30.

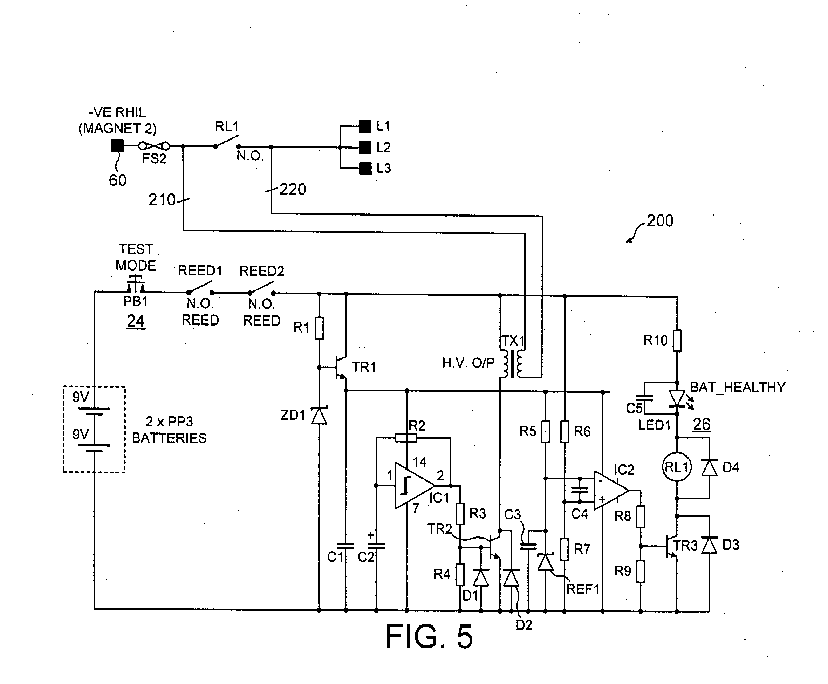

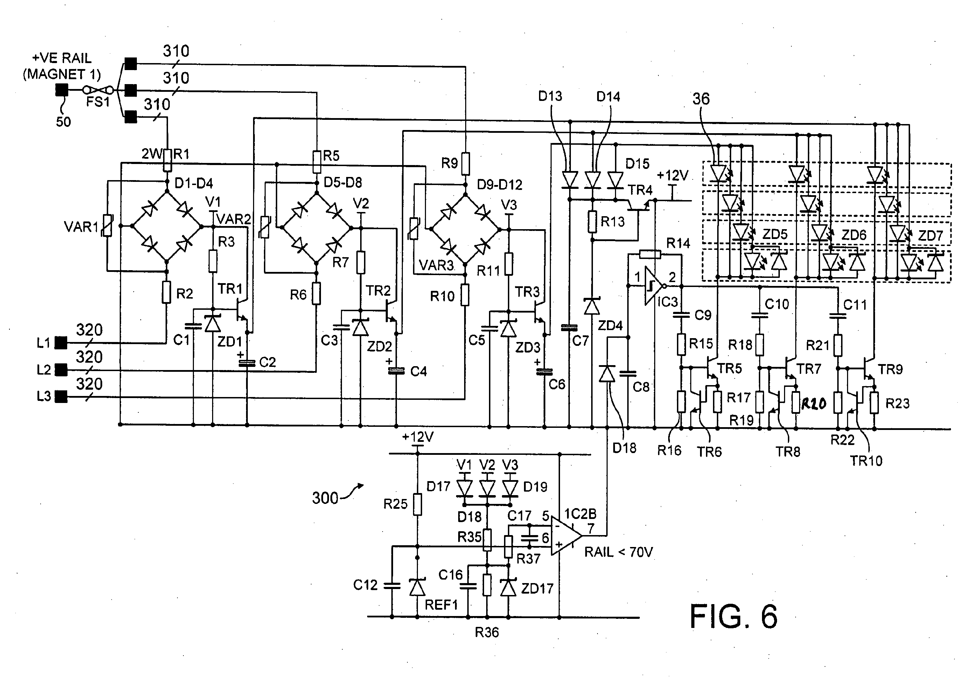

The circuitry of the device 10 is now described in more detail with reference to Figures 5 and 6.

Figure 5 shows circuitry in the operator housing 20 in the form of battery-powered test circuitry 200. The test circuitry 200 includes a two PP9 9V batteries, the button 24 and the LED 26. One terminal 210 of the test circuitry 200 is connected via a fuse FS2 to the rail terminal plates (schematically shown at 60). Another terminal 220 of the test circuitry is connected to one end of each of three electrical connectors L1,L2,L3 of the electrical cable 40. A relay RL1 is provided that, when closed, short-circuits the test circuitry 200 so that the rail terminal plates 60 are directly connected to the one end of each of the three electrical connectors L1,L2,L3 therethrough. The relay RL1 is operable to open upon operation of the button 24.

Figure 6 shows circuitry in the indicator housing 30 in the form of detect and drive circuitry 300. Three first terminals 310 of the detect and drive circuitry 300 are connected to the rail terminal plates 50 of the indicator housing 30 via a fuse FS1. Three second terminals 320 of the detect and drive circuitry 300 are each connected to the other end of a respective one of the three electrical connectors L1,L2,L3 of the electrical cable 40. In between each one of the three first terminals 310 and a respective one of the three second terminals 320 is a separate rectifier circuit, LED driver circuit, and a group of indicators in the form of four LEDs 36. It should be noted that each of the four clusters 34 of LEDs 36 described previously with reference to Figure 1 includes one LED 36 from each of the three groups thereof. Thus it can be seen that the detect and drive circuitry 300 is comprised of three parallel, but substantially identical branches.

In operation and with reference to Figures 4 and 5, self-testing of the device 10 is carried out before the device 10 is used to check whether conductor rails of a railway track are live. This is in order to verify that the device 10 is in working order. Self-testing is carried out by placing the rail terminal plates 50 of the indicator unit 30 in face-to-face contact with those 60 of the operator unit 20. Recalling that the two sets of plates 50,60 are each of opposite polarity to the other, the two housings 20,30 are thus held together by the plates 50,60. When the two housings are attached together in this way reed relays REED1,REED2 of the test circuitry 200 are operated by actuating magnets (not shown) within the operator housing 20 and closed. The button 24 is then depressed by an operator and this causes both the relay RL1 to open and connects the batteries with the remainder of the test circuit 200 such that a stepped-up voltage therefrom is connected across the terminals 210,220 and hence across the rail terminal plate 60 of the operator housing 20 and the one end of each of the three conductors L1,L2,L3 of the electrical cable 40. It is envisaged that the stepped-up voltage is approximately 200V.

During self-testing, the test circuitry 200 is arranged to test the remaining capacity of the battery. The LED 20 is illuminated during self-testing unless it is found that the insufficient capacity remains for the operation of at least 10 self-tests, each of 5 seconds duration, wherein the LED 26 is not illuminated in order to communicate this to the user.

As the rail terminal plate 60 of the operator housing 20 and the one end of each of the three conductors L1,L2,L3 are respectively connected to the rail terminal plate 50 of the indicator housing 30 and the other end of each of the three conductors L1,L2,L3, the stepped-up voltage is connected across the two latter components and hence across each of the three branches of the detect and drive circuitry 300. Each branch of the detect and drive circuitry 300 is arranged to be operable to cause the group of LEDs 36 included therein to flash on and off when a voltage greater than 60V DC or 60V AC is connected thereacross. Thus if each of the three LEDs 36 of each cluster 34 thereof flashes, this means that each branch of the detect and drive circuitry 300 is operable and that the device 10, in turn, is operable.

Operation of the device 10 to ascertain whether or not a high potential supply is connected across conductor rails (not shown) of a railway track is by placing the operator housing 20 on one of the conductor rails such that its rail terminal plates 60 are in contact with the rail and such that the magnetic attraction of the plates 60 holds that housing 20 firmly in place. The indicator housing 30 is attached to the other of the conductor rails in a similar fashion.

If the conductor rails are live, a large potential difference, is connected across the two sets of rail terminal plates 50,60. Because the button 24 is not depressed, the relay RL1 remains closed, thereby short-circuiting out the test circuitry 200 and provide direct contact between the one end of each of the three conductors L1,L2,L3 of the electrical cable 40 and the rail terminal plate 60 of the operator housing 20. Thus, the large potential difference is connected across each of the three branches of the detect and drive circuitry 300 causing each of the three groups of LEDs 36 to flash on and off, indicating that the conductor rails are live.

If the conductor rails are not live, or have a voltage of less that 60V DC or 60V AC thereacross that would most likely not be of danger to a worker exposed thereto, the potential difference across each of the three branches of the detect and drive circuitry 300 is insufficient to cause the LEDs 36 to flash. Instead, the LEDs 36 remain off.

Once the conductor rails have been tested in this way, the two housings 20,30 are removed therefrom and the aforementioned self-test procedure is repeated to check that the device 10 is still operable.

Further features of this exemplary embodiment are described in the document annexed hereto and are hereby incorporated into this description.

## Claims

1. According to an aspect of this invention, there is provided, a device for detecting a potentially hazardous potential difference between conductor rails of a railway track, the device including first and second portions electrically connected to one another, each portion including electrical contact means for placing in electrical contact with a respective one of the conductor rails, and at least one of the portions including indicator means to indicate to a user whether or not a potentially hazardous potential difference exists between the conductor rails when the electrical contact means are so placed, wherein the device is further arranged to self-test when the electrical contact means of each portion are placed in contact with each other.

2. A device according to claim 1, wherein the device is arranged to self-test by establishing a potential difference between the electrical contact means of each portion of the device such that when those means are placed in contact with each other a current flows in the device and the indicator means is operated, thereby checking that the device may be used to indicate whether or not a potentially hazardous potential difference exists between conductor rails.

3. A device according to claim 1 or claim 2, wherein the indicator means includes a plurality of groups of indicators, each group being operable by a respective circuit running between the electrical contact means of the first portion and the electrical contact means of the second portion, and wherein each group includes one or more indicators.

4. A device according to claim 3, wherein each group includes a respective electrical connection between the first portion and the second portion.

5. A device according to claim 3 or claim 4, wherein there are three groups of indicators, each being part of, and operable by, a respective one of the circuits.

6. A device according to any one of claims 3 to 5, wherein the indicator means includes one or more LEDs.

7. A device according to any one of claims 3 to 6, wherein each group includes a plurality of indicators, a respective indicator of each group being placed together in a juxtaposed cluster on the at least one of the portions to give the same number of clusters as indicators in each group, each cluster being spaced from each other cluster.

8. A device according to any one of claims 3 to 7, wherein each group includes four LEDs, a respective LED of each group being placed together in a juxtaposed cluster on the at least one of the portions to give four such juxtaposed clusters, each spaced from the other and arranged to maximise the likelihood of the LEDs being seen by a user.

9. A device according to claim 6 or claim 8, wherein the juxtaposed clusters are arranged such that at least two such clusters can be seen by the user during normal operation.

10. A device according to any one of claims 6 to 9, wherein the device is arranged such that the LEDs flash on and off when the electrical contact means are placed in contact with a potentially hazardous potential difference.

11. A device according to any preceding claim, wherein the indicator means includes an audible indicator, such as an alarm, buzzer or some such similar means.

12. A device according to any preceding claim, wherein the device includes a power source, such as a battery, operable to establish the potential difference between the electrical contact means of each portion of the device during the self-test, and the device also includes switch means operable by a user to connect the power source across the electrical contact means for carrying out of the self-test.

13. A device according to claim 12, wherein the device includes power source indicator means that is operable during the self-test, preferably by operation of the switch means, to give an indication indicative of strength and/or predicted useful life of the power source.

14. A device according to any preceding claim, wherein each portion includes a respective, substantially closed, housing and each housing includes the respective electrical contact means mounted therein.

15. A device according to claim 14, wherein each housing includes a handle arranged for gripping by a user and such that each of the electrical contact means can be placed in contact with a respective one of the conductor rails.

16. A device according to any preceding claim, wherein the electrical connection between the first portion and the second portion is provided by an electrical cable extending between the two housings.
